# EUROPEAN PATENT SPECIFICATION

(11) **EP 4 238 126 B1**
(45) Date of publication and mention of the grant of the patent: **02.12.2026**
(21) Application number: 21887827.0
(22) Date of filing: 28.10.2021
(51) Int. Cl.: H10W 80/00

(54) **DIRECT BONDING METHOD**
DIREKTBINDUNGSVERFAHREN
PROCÉDÉ DE LIAISON DIRECTE

(30) Priority: 29.10.2020 US 202063107280 P
(43) Date of publication of application: 06.09.2023
(73) Proprietor: Adeia Semiconductor Bonding Technologies Inc., San Jose, CA 95134 (US)
(72) Inventor: GAO, Guilian, San Jose, California 95134 (US); UZOH, Cyprian, Emeka, San Jose, California 95134 (US); MIRKARIMI, Laura, Wills, San Jose, California 95134 (US); FOUNTAIN, JR., Gaius, Gillman, San Jose, California 95134 (US)
(74) Representative: Murgitroyd & Company
(86) International application number: PCT/US2021/072083
(87) International publication number: WO 2022/094579

(56) References cited:
- WO-A1-2018/194827
- WO-A1-2018/194827
- US-A1- 2004 235 266
- US-A1- 2004 235 266
- US-A1- 2005 031 795
- US-A1- 2013 026 643
- US-A1- 2019 252 364

## Description

### BACKGROUND

### Field

The field relates to direct bonding methods and structures.

### Description of the Related Art

The demand for more compact physical arrangements of microelectronic elements such as integrated chips and device dies has become even more intense with the rapid progress of portable electronic devices, the expansion of the Internet of Things, nanoscale integration, subwavelength optical integration, and more. Merely by way of example, devices commonly referred to as "smart phones" integrate the functions of a cellular telephone with powerful data processors, memory and ancillary devices such as global positioning system receivers, electronic cameras, and local area network connections along with high-resolution displays and associated image processing chips. Such devices can provide capabilities such as full internet connectivity, entertainment including full-resolution video, navigation, electronic banking, sensors, memories, microprocessors, healthcare electronics, automatic electronics, and more, all in a pocket-size device. Complex portable devices require packing numerous chips and dies into a small space.

Microelectronic elements often comprise a thin slab of a semiconductor material, such as silicon or gallium arsenide or others. Chips and dies are commonly provided as individual, prepackaged units. In some unit designs, the die is mounted to a substrate or a chip carrier, which is in turn mounted on a circuit panel, such as a printed circuit board (PCB). Dies can be provided in packages that facilitate handling of the die during manufacture and during mounting of the die on the external substrate. For example, many dies are provided in packages suitable for surface mounting. Numerous packages of this general type have been proposed for various applications. Most commonly, such packages include a dielectric element, commonly referred to as a "chip carrier" with terminals formed as plated or etched metallic structures on the dielectric. The terminals typically are connected to the contact pads (e.g., bond pads or metal posts) of the die by conductive features such as thin traces extending along the die carrier and by fine leads or wires extending between the contacts of the die and the terminals or traces. In a surface mounting operation, the package may be placed onto a circuit board so that each terminal on the package is aligned with a corresponding contact pad on the circuit board. Solder or other bonding material is generally provided between the terminals and the contact pads. The package can be permanently bonded in place by heating the assembly so as to melt or "reflow" the solder or otherwise activate the bonding material.

Many packages include solder masses in the form of solder balls that are typically between about 0.025 mm and about 0.8 mm (1 and 30 mils) in diameter, and are attached to the terminals of the package. A package having an array of solder balls projecting from its bottom surface (e.g., surface opposite the front face of the die) is commonly referred to as a ball grid array or "BGA" package. Other packages, referred to as land grid array or "LGA" packages are secured to the substrate by thin layers or lands formed from solder. Packages of this type can be quite compact. Certain packages, commonly referred to as "chip scale packages," occupy an area of the circuit board equal to, or only slightly larger than, the area of the device incorporated in the package. This scale is advantageous in that it reduces the overall size of the assembly and permits the use of short interconnections between various devices on the substrate, which in turn limits signal propagation time between devices and thus facilitates operation of the assembly at high speeds.

Semiconductor dies can also be provided in "stacked" arrangements, wherein one die is provided on a carrier, for example, and another die is mounted on top of the first die. These arrangements can allow a number of different dies to be mounted within a single footprint on a circuit board and can further facilitate high-speed operation by providing a short interconnection between the dies. Often, this interconnect distance can be only slightly larger than the thickness of the die itself. For interconnection to be achieved within a stack of die packages, interconnection structures for mechanical and electrical connection may be provided on both sides (e.g., faces) of each die package (except for the topmost package). This has been done, for example, by providing contact pads or lands on both sides of the substrate to which the die is mounted, the pads being connected through the substrate by conductive vias or the like.

Dies or wafers may also be stacked in other three-dimensional arrangements as part of various microelectronic packaging schemes. This can include stacking layers of one or more dies or wafers on a larger base die or wafer, stacking multiple dies or wafers in vertical or horizontal arrangements, or stacking similar or dissimilar substrates, where one or more of the substrates may contain electrical or non-electrical elements, optical or mechanical elements, and/or various combinations of these. Dies or wafers may be bonded in a stacked arrangement using various bonding techniques, including direct dielectric bonding, non-adhesive techniques, such as ZiBond^{®} or a hybrid bonding technique, such as DBI^{®}, both available from Invensas Bonding Technologies, Inc. (formerly Ziptronix, Inc.), an Xperi company (see for example, U.S. Pat. Nos. 6,864,585 and 7,485,968, which are incorporated herein in their entirety). When bonding stacked dies using a direct bonding technique, it is usually desirable that the surfaces of the dies to be bonded be extremely flat and smooth. For instance, in general, the surfaces should have a very low variance in surface topology, so that the surfaces can be closely mated to form a lasting bond. For example, it is generally preferable that the variation in roughness of the bonding surfaces be less than 3 nm and preferably less than 1.0 nm.

Some stacked die arrangements are sensitive to the presence of particles or contamination on one or both surfaces of the stacked dies. For instance, particles remaining from processing steps or contamination from die processing or tools can result in poorly bonded regions between the stacked dies, or the like. Extra handling steps during die processing can further exacerbate the problem, leaving behind unwanted residues.

WO 2018/194827 discloses a method of forming a microelectronic assembly, comprising providing a protective layer on one or both surfaces of a substrate; fixing the substrate onto a carrier; singulating the substrate into a quantity of dies fixed to the carrier; processing at least a first surface of the dies while the dies are fixed to the carrier; cutting the carrier around a perimeter of a first die, the cutting forming a portion of the carrier fixed to a second surface of the first die; removing the first die from the quantity of dies while the portion of the carrier is fixed to the second surface of the first die; and attaching the first die to a prepared surface of a substrate, the first surface of the first die being attached to the prepared surface of the substrate.

US 2004/235266 discloses a method of bonding including using a bonding layer having a fluorinated oxide. Fluorine is introduced into the bonding layer by exposure to a fluorine-containing solution, vapor or gas or by implantation. The bonding layer is formed using a method where fluorine is introduced into the layer during its formation. The surface of the bonding layer is terminated with a desired species, preferably an NH₂ species. This is accomplished by exposing the bonding layer to an NH₄OH solution. High bonding strength is obtained at room temperature.

US 2005/031795 discloses a method comprising plasma treatment of a polymeric material, where the polymeric material comprises a silicone organic copolymer, plasma treatment of an adherend, and thereafter contacting the polymeric material and the adherend; thereby creating adhesion of the polymeric material and the adherend; where the method is carried out during fabrication of an electronic device, an electronic device package, a photonic device, or an optoelectronic device.

US 2013/026643 discloses a method of fabricating multi-die assemblies including a wafer segment having no integrated circuitry thereon and having a plurality of vertically stacked dice thereon electrically interconnected by conductive through vias, resulting multi-die assemblies, and semiconductor devices comprising such multi-die assemblies. The wafer segment may function as a heat sink to enhance heat transfer from the stacked dice in the resulting multi-die assembly. The die stacks are fabricated at the wafer level on a base wafer, from which the wafer segment and die stacks are singulated after at least peripheral encapsulation.

US 2019/252364 discloses a method of forming a microelectronic assembly, comprising preparing a bonding surface of a first substrate, including planarizing the bonding surface of the first substrate to have a first predetermined minimal surface variance; and plasma activating the bonding surface of the first substrate; preparing a bonding surface of a second substrate, including planarizing the bonding surface of the second substrate to have a second predetermined minimal surface variance; mounting the second substrate to a dicing sheet or dicing tape held by a dicing frame; singulating the second substrate into a plurality of dies while the second substrate is mounted to the dicing sheet or dicing tape, each die of the plurality of dies having a bonding surface comprising a portion of the bonding surface of the second substrate; processing the plurality of dies while the plurality of dies is mounted to the dicing sheet or dicing tape; selecting a die of the plurality of dies using a pick and place tool; and directly bonding the bonding surface of the die to the bonding surface of the first substrate without adhesive, and without activating the bonding surface of the die.

### SUMMARY

According to the present invention, there is provided a method for preparing a first element for direct bonding to a second element according to claim 1.

### BRIEF DESCRIPTION OF THE DRAWINGS

Figure 1 is a flow chart illustrating a method not according to the claimed invention for forming a bonded structure.
Figure 2A-2B are flow charts illustrating example methods for forming a bonded structure, according to various embodiments which fall within the scope of the claimed invention.
Figures 3A-3E schematically illustrate the bonding method according to Figure 2.
Figure 4 is a flow chart illustrating a method not according to the claimed invention for forming a bonded structure.

### DETAILED DESCRIPTION

Two or more semiconductor elements (such as integrated device dies, wafers, etc.) may be stacked on or bonded to one another to form a bonded structure. Conductive contact pads of one element may be electrically connected to corresponding conductive contact pads of another element. Any suitable number of elements can be stacked in the bonded structure. As used herein, contact pads may include any suitable conductive feature within an element configured to bond (*e.g*., directly bond without an adhesive) to an opposing conductive feature of another element. For example, in some embodiments, the contact pad(s) may comprise a discrete metallic contact surface formed in a bonding layer of an element. In some embodiments, the contact pad(s) may comprise exposed end(s) of a through-substrate via (TSV) that extends at least partially through an element.

In some embodiments, the elements are directly bonded to one another without an adhesive. In various embodiments, a dielectric field region (also referred to as a nonconductive bonding region) of a first element (*e.g.,* a first semiconductor device die with active circuitry) can be directly bonded (*e.g*., using dielectric-to-dielectric bonding techniques) to a corresponding dielectric field region of a second element (*e.g.,* a second semiconductor device die with active circuitry) without an adhesive. For example, dielectric-to-dielectric bonds may be formed without an adhesive using the direct bonding techniques disclosed at least in U.S. Patent Nos. 9,564,414; 9,391,143; and 10,434,749.

In various embodiments, hybrid direct bonds can be formed without an intervening adhesive. For example, dielectric bonding surfaces can be polished to a high degree of smoothness. The bonding surfaces can be cleaned and exposed to a plasma and/or etchants to activate the surfaces. In some embodiments, the surfaces can be terminated with a species after activation or during activation (*e.g*., during the plasma and/or etch processes). Without being limited by theory, in some embodiments, the activation process can be performed to break chemical bonds at the bonding surface, and the termination process can provide additional chemical species at the bonding surface that improves the bonding energy during direct bonding. In some embodiments, the activation and termination are provided in the same step, *e.g.,* a plasma or wet etchant to activate and terminate the surfaces. In other embodiments, the bonding surface can be terminated in a separate treatment to provide the additional species for direct bonding. In various embodiments, the terminating species can comprise nitrogen. Further, in some embodiments, the bonding surfaces can be exposed to fluorine. For example, there may be one or multiple fluorine peaks near layer and/or bonding interfaces. Thus, in the directly bonded structures, the bonding interface between two dielectric materials can comprise a very smooth interface with higher nitrogen content and/or fluorine peaks at the bonding interface. Additional examples of activation and/or termination treatments may be found throughout U.S. Patent Nos. 9,564,414; 9,391,143; and 10,434,749.

In various embodiments, conductive contact pads of the first element can be directly bonded to corresponding conductive contact pads of the second element. For example, a hybrid bonding technique can be used to provide conductor-to-conductor direct bonds along a bond interface that includes covalently direct bonded dielectric-to-dielectric surfaces, prepared as described above. In various embodiments, the conductor-to-conductor (*e.g*., contact pad to contact pad) direct bonds and the dielectric-to-dielectric hybrid bonds can be formed using the direct bonding techniques disclosed at least in U.S. Patent Nos. 9,716,033 and 9,852,988.

For example, dielectric bonding surfaces can be prepared and directly bonded to one another without an intervening adhesive as explained above. Conductive contact pads (which may be surrounded by nonconductive dielectric field regions) may also directly bond to one another without an intervening adhesive. In some embodiments, the respective contact pads can be recessed below exterior (*e.g*., upper) surfaces of the dielectric field or nonconductive bonding regions, for example, recessed by less than 20 nm, less than 15 nm, or less than 10 nm, for example, recessed in a range of 2 nm to 20 nm, or in a range of 4 nm to 10 nm. The nonconductive bonding regions can be directly bonded to one another without an adhesive at room temperature in some embodiments and, subsequently, the bonded structure can be annealed. Upon annealing, the contact pads can expand and contact one another to form a metal-to-metal direct bond. Beneficially, the use of Direct Bond Interconnect, or DBI^{®}, techniques can enable high density of pads connected across the direct bond interface (e.g., small or fine pitches for regular arrays). In some embodiments, the contact pads can be arranged in an array having a regular or irregular pitch. In some embodiments, to the extent the contacts are regularly spaced from one other across the element, or across groups within the element, the pitch of the contact pads may be less 40 microns, less than 10 microns, or less that 2 microns. For some embodiments, the ratio of the pitch of the contact pads to a dimension (*e.g*., a diameter) of the contact pad can be less than 5, less than 3, or less than 2. In various embodiments, the contact pads can comprise copper, although other metals may be suitable.

In various embodiments, the contact pads can be formed in respective first and second arrays of pads on the first and second elements. If any debris or surface contaminant is present at the surface of the first or second elements, voids may be created at the bond interface, or debris may intervene between opposing contact pads. In addition, reactant byproducts generated during bonding and annealing, *e.g*. hydrogen and water vapor, may also form voids at the bond interface. These voids may effectively inhibit the joining of particular contact pads in the vicinity, creating openings or other failures in the bond. For example, any void larger than the pad diameter (or pitch) can potentially create an opening and direct bond failure. In some embodiments, depending on the location of the voids, voids that are comparable in size to or smaller than the pad diameter (at least partially located over pad) may be the source of failure in the bonded structure or structures.

Thus, in direct bonding processes, a first element can be directly bonded to a second element without an intervening adhesive. In some arrangements, the first element can comprise a singulated element, such as a singulated integrated device die. In other arrangements, the first element can comprise a carrier or substrate (*e.g*., a wafer) that includes a plurality (*e.g*., tens, hundreds, or more) of device regions that, when singulated, form a plurality of integrated device dies. Similarly, the second element can comprise a singulated element, such as a singulated integrated device die. In other arrangements, the second element can comprise a carrier or substrate (*e.g*., a wafer).

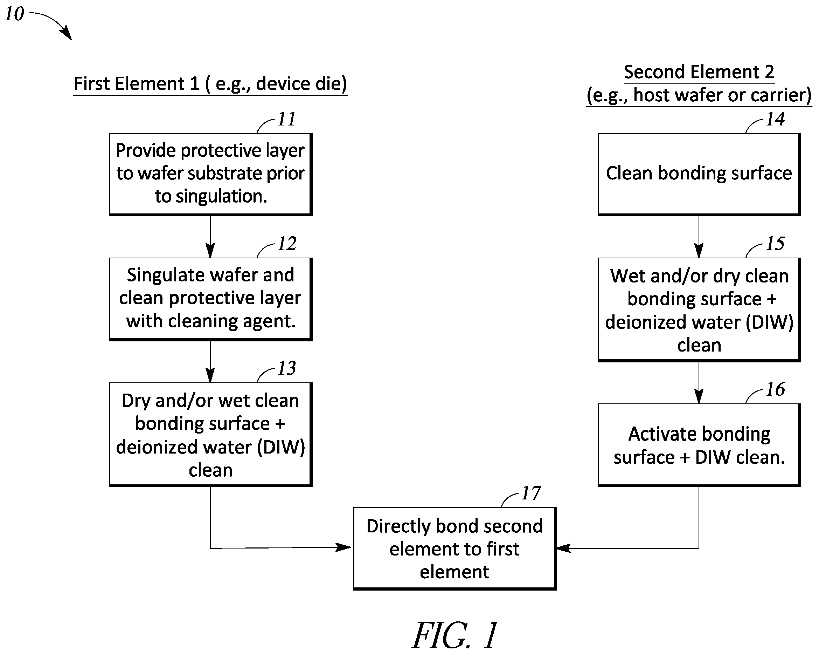

Figure 1 is a flow chart showing an example method 10 of forming a bonded structure. As an example, as shown in the flow chart of Figure 1, the bonded first element 1 can comprise a singulated device die, and the bonded second element can comprise a host substrate, such as a wafer or carrier. In other arrangements, the second element 2 can comprise a second singulated device die. The first element 1 can be planarized or polished to have a smoothness sufficient for direct bonding. In the illustrated arrangement, the first element 1 may be initially provided in wafer form or as a larger substrate and singulated to form the singulated first element 1. However, the singulation process and/or other processing steps may produce debris that can contaminate the planar bonding surface, which can leave voids and/or defects when two elements 1, 2 are bonded. Accordingly, prior to singulation, in a block 11, a protective layer can be provided over the bonding surface of the first element 1 (*e.g.,* in wafer form) before activation and before direct bonding in order to prevent debris from contaminating the bonding surface of the first element 1. The protective layer can comprise an organic or inorganic layer (*e.g.,* a photoresist) that is deposited (*e.g.,* spin coated onto) the polished bonding surface of the first element 1 in wafer form. Additional details of the protective layer may be found throughout U.S. Patent No. 10,714,449. In a block 12, the wafer containing the first element 1 can be thinned and singulated using any suitable method. The first element 1 can be thinned prior to singulation. The protective layer over the bonding surface can beneficially protect the bonding surface of the first element 1 from debris generated during singulation.

As shown in a block 13 of Figure 1, the protective layer (such as an organic layer) on the singulated first element 1 can be removed from the bonding surface with a cleaning agent, for example with a suitable solvent, such as an alkaline solution or other suitable cleaning agent as recommended by the supplier of the protective layer. The protective layer cleaning agent can be selected such that it does not substantially roughen the smooth bonding surface of the dielectric bonding layer and does not substantially etch the metal of the contact pad to increase the recess of the pad metal. An excessive pad recess may form a recess that is too deep, which may prevent (or reduce the strength of) pad-to-pad bonding at the appropriate annealing conditions (*e.g*., annealing temperature and times). For example, the annealing temperature may vary in a range of 150°C to 350°C or higher. The annealing times may range between 5 minutes to over 120 minutes. The cleaning agent can be applied by a fan spray of the liquid cleaning agent or other known methods. For example, the cleaned bonding surface of the first element 1 can be ashed (*e.g*., using an oxygen plasma) and cleaned with deionized water (DIW). The ashing step can remove any residual organic material from the protective layer. In some embodiments, the cleaned and singulated first element can be activated before direct bonding. In other embodiments, however, the cleaned and singulated first element may not be activated before direct bonding.

In a block 14, the second element 2 can also be cleaned with DIW after planarization or polishing. In a block 15, the bonding surface can also be wet and/or dry cleaned, *e.g.,* the bonding surface of the second element 2 can be ashed (*e.g.,* using an oxygen plasma) to remove any organic material and cleaned with DIW. Further, as shown in a block 16 of Figure 1, the bonding surface of the second element 2 can be activated. The activation can comprise exposing the bonding surface of the second element 2 to a nitrogen plasma. The activation can comprise exposing the bonding surface of the second element 2 to an oxygen plasma. As explained above, the activation process (which may also terminate the bonding surface) can break bonds at the bonding surface and replace the broken bonds with chemical species that enhance the bonding energy of the direct bond. As shown in block 16 of Figure 1, the activated surface can be cleaned with DIW, which may serve to wash any residue away before bonding without degrading the bonding surface of the second element.

In a block 17, the first and second elements 1, 2 can be brought together to directly contact one another at room temperature. For example, in the illustrated arrangement, the singulated first element 1 in the form of a singulated device die can be directly bonded to the second element 2 in wafer form. In other arrangements, the singulated first element 1 can be directly bonded to a singulated second element 2 (*e.g,* such that both elements 1, 2 are in the form of a device die). In still other arrangements, the first and second elements 1, 2 may be directly bonded in wafer form and subsequently singulated. As explained herein, the nonconductive bonding regions of the first and second elements 1, 2 can spontaneously bond at room temperature when placed in contact without application of external pressure, and without application of a voltage. The bonded structure can be annealed to cause the conductive contact pads to expand and form electrical connections and to increase the bonding energy between the respective bonded nonconductive bonding regions of the first and second elements 1, 2. In the illustrated arrangement, the second element 2 comprises a wafer or other larger carrier substrate, but in other arrangements, the second element 2 can comprise a singulated integrated device die.

In the bonding arrangement shown in Figure 1, only the second element 2 may be activated before direct bonding. As explained in U.S. Patent No. 10,727,219, the bonded strength between the two elements 1, 2 may be sufficiently strong when only one of the two elements 1, 2 is activated before bonding. However, in other arrangements, both the first element 1 and the second element 2 may be activated prior to bonding, or, alternatively, only the first element 1 may be activated before bonding.

In the arrangement of Figure 1, the activation of the first element 1 can occur after the protective layer is applied, and after singulation and removal of the protective material. However, if the first die or element 1 is activated in the process of Figure 1 while the first element 1 is supported by dicing tape, the dicing tape can react with a nitrogen plasma to deposit undesirable byproducts on portions of the first element 1 and/or second element 2 disposed on the dicing tape during the activation step. In some instances, post deionized water (DIW) cleaning of the bonding surfaces of the first elements 1 may not be effective in removing these surface-degrading byproducts from the bonding surface of the first element. Bonding improperly cleaned bonding surfaces typically produces defective bonded region(s) between the bonded elements.

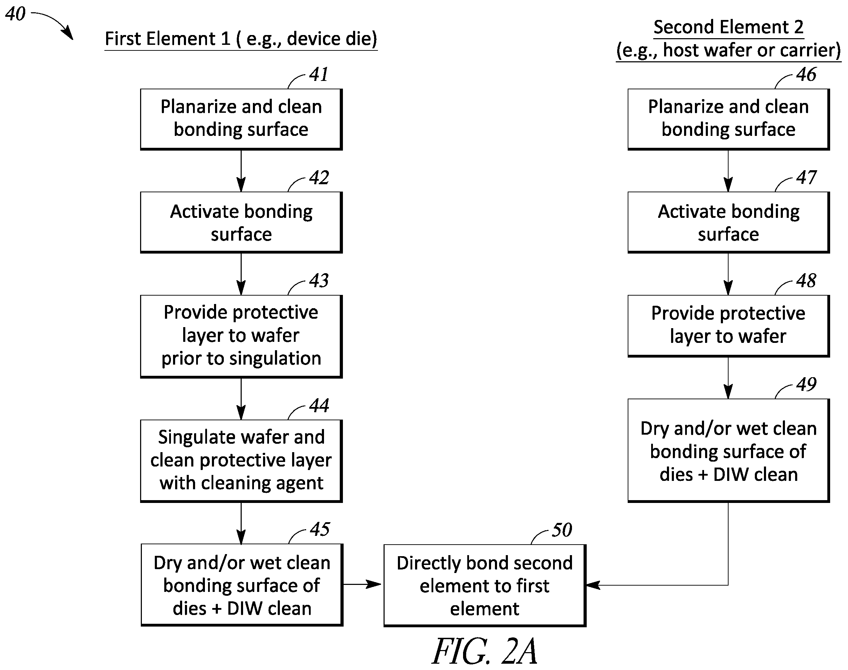

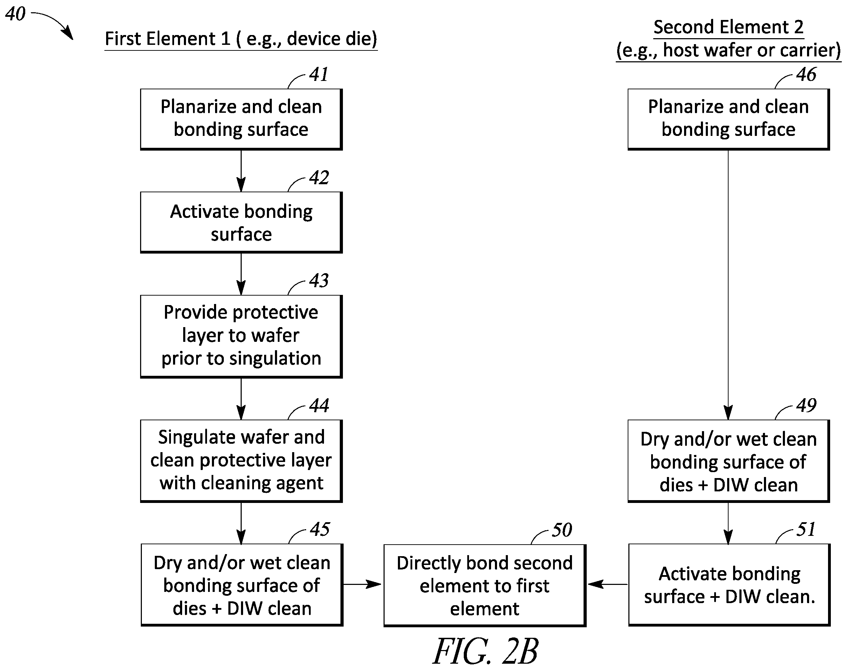

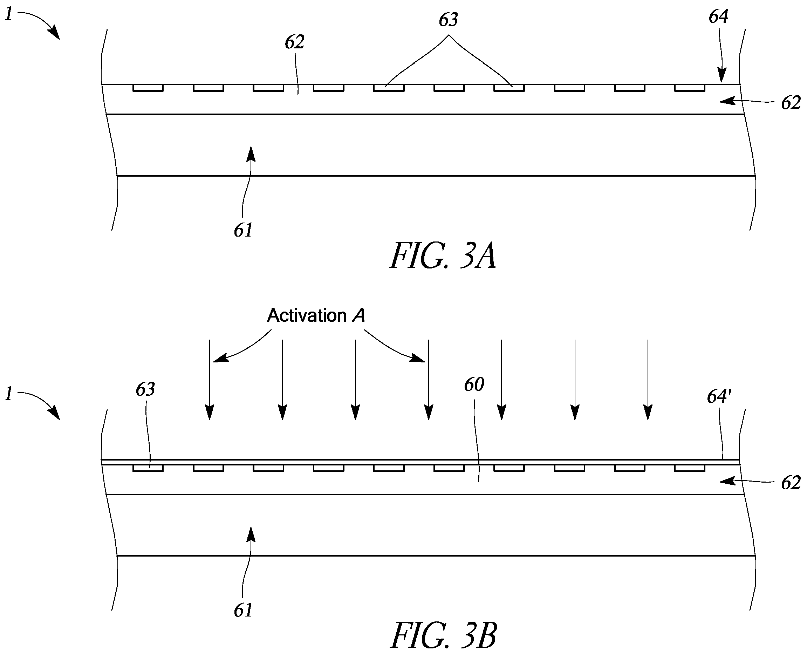

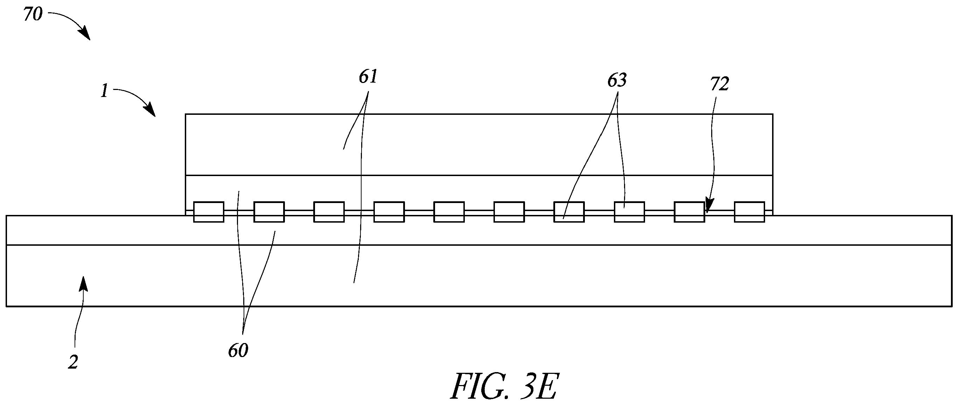

Figures 2A and 3A-3E schematically illustrate a bonding method according to various embodiments. In particular, Figure 2A schematically illustrates an example process flow for the first and second elements 1, 2. Figure 3A-3D illustrate the process flow for the first element 1 before direct bonding is performed in Figure 3E and in block 51 of Figure 2A. Figure 3A illustrates a schematic side sectional view of the first element 1. The first or second element 1, 2 can comprise an integrated device die or a wafer. In the step of Figure 3A, the first element 1 is shown in wafer form. The first element 1 can comprise a base portion 61, which can comprise a semiconductor material, such as silicon. Active devices (and/or passive devices) can be formed in or on the base portion 61. A bonding layer 62 can be provided (*e.g*., deposited) on the base portion 61. In various embodiments, the bonding layer 62 can comprise a nonconductive bonding region 60 (*e.g.,* a dielectric field region) that includes an inorganic dielectric. For example, in some embodiments, the nonconductive bonding region 60 can comprise silicon oxide, a silicon-containing dielectric layer such as one or more of SiN, SiOₓN_{y}, silicon carbide, silicon carbonitride or silicon carboboride etc. The nonconductive bonding region 60 may also comprise a non-silicon dielectric layer, for example, ceramic layers, such as alumina or sapphire, zirconia, boron carbide, boron oxide, aluminum nitride, piezoceramics, ferro ceramics, zinc oxide, zirconium dioxide, titanium carbide etc. According to the invention, the bonding layer 60 further includes a plurality of conductive contact pads 63 formed in the nonconductive bonding region (in some embodiments, the contact pads can comprise exposed surfaces of TSVs, as noted above). In various embodiments, the contact pads 63 can comprise copper, copper alloys, or nickel and nickel alloys, although other suitable metals can be used. In a block 41 of Figure 2 and as shown in Figure 3A, the bonding layer 62 can comprise a bonding surface 64 that can be cleaned and polished or planarized (*e.g*., using chemical mechanical polishing, or CMP) to a very high degree of smoothness. Exposed surfaces (*e.g*., upper surfaces) of the contact pads 63 may be recessed relative to the exterior bonding surface 64 of the nonconductive bonding region 60. For example, the exposed surfaces of the pads 63 can be recessed relative to the exterior bonding surface 64 of the nonconductive bonding region 60 by less than 20 nm, less than 15 nm, or less than 10 nm, for example, recessed in a range of 2 nm to 20 nm, or in a range of 4 nm to 10 nm.

Turning to a block 42 of Figure 2A and to Figure 3B, the bonding layer 62 can be activated for direct bonding after the polishing of block 41 to form an activated surface 64'. For example, the bonding layer 62 can be exposed to a plasma comprising an activation species. In some embodiments, the plasma can comprise a nitrogen-containing species. For example, in embodiments in which the nonconductive bonding region 60 comprises silicon oxide or silicon carbonitride, the use of a nitrogen-containing plasma for activation can provide strong bonding energies. In other embodiments, the plasma can comprise an oxygen-containing plasma. For example, in embodiments in which the nonconductive bonding region 60 comprises silicon nitride or silicon carbonitride, the use of an oxygen-containing plasma for activation can provide strong bonding energies.

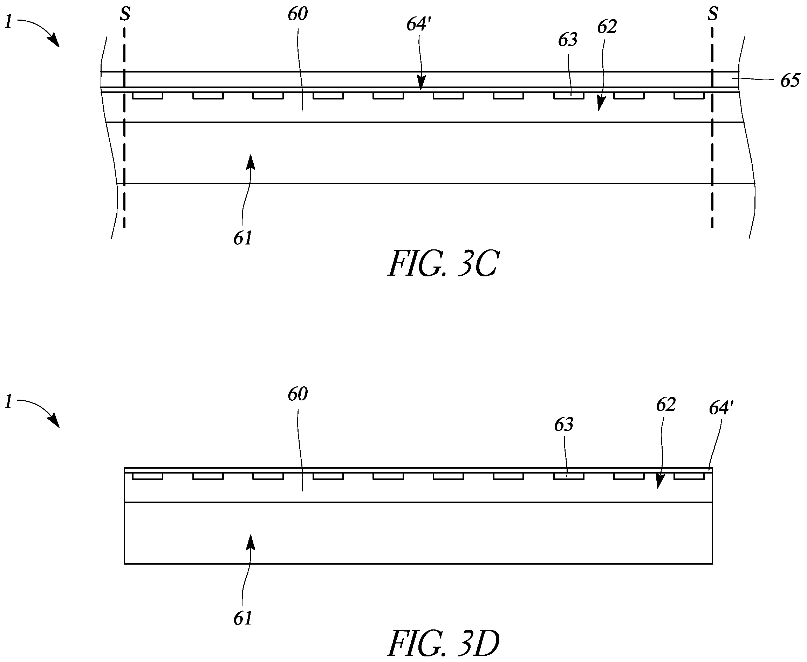

In a block 43 of Figure 2A and in Figure 3C, a protective layer 65, for example an organic protective layer (*e.g.,* a photoresist), can be formed onto the activated surface 64' of the bonding layer 62. The protective layer 65 can serve to protect the activated bonding surface 64' during thinning (which in various embodiments may be performed before singulation) and singulation so as to prevent voids from forming after bonding. After providing the protective layer 65, as shown in a block 44 of Figure 2A and in Figure 3D, the first element 1 in wafer form (*e.g.,* an activated substrate with the protective layer 65), can be thinned and singulated along saw streets S to form a plurality of singulated first elements 1 in the form of singulated device die(s). Beneficially, the protective layer 65 can protect the activated bonding surface 64' during the singulation process (and other processing) from debris or damage. As shown in block 45 of Figure 2A and in Figure 3D, the protective layer 65 can be removed with a cleaning agent as described herein (*e.g.,* a dry and/or wet cleaning process). In some embodiments, the cleaned singulated elements 1 may be ashed (*e.g.,* exposed to an oxygen plasma) to remove any unwanted residues. As shown in block 45 of Figure 2A and in Figure 3D, the singulated first element 1 can be cleaned with deionized water (DIW), leaving the activated bonding surface 64' exposed and ready for direct bonding. In some applications where the metallic surfaces of the pads 63 are exposed to oxygen plasma, a very thin layer of metallic oxide may form over the pads 63 (*e.g.,* in the case of copper pads, a copper oxide film). The metal oxide film over the pad surface may be selectively removed by cleaning the surface of the substrate with a very dilute inorganic or organic acid solution to selectively remove the thin oxide layer without damaging the bonding surface 64' of the nonconductive region 60 and without forming an excessive recess in the pads 63.

As shown in Figure 2A, the second element 2 can be processed in a similar manner, or in a different manner. For example, in a block 46, the bonding surface of the second element 2 (which can be a wafer or a die) can be planarized and cleaned. In some embodiments, as shown in a block 47 of Figure 2A, the second element 2 can also be activated as explained above before a protective layer 65 is applied to the activated surface 64' in a block 48. In other embodiments, the second element 2 may not be activated at all, or, as shown in Figure 2B, for example, may not be activated before the application of a protective layer 64. In some embodiments, no protective layer may be applied over the second element 2. In the illustrated embodiment, the protective layer can protect the bonding surface from debris and/or damage, e.g., that may occur during singulation, other processing steps, or transport between different facilities (*e*.*g*., during transportation between the wafer foundry and the bonding facility. The bonding surface of the second element 2 can be cleaned in a block 49. For example, in the embodiment of Figure 2A in which the protective layer is applied, the protective layer can be removed and/or ashed. In block 49, wet and/or dry cleaning process(es) can be performed on the second element 2 to remove debris (including, *e.g.,* a DIW cleaning step).

In some embodiments, the first element 1 and/or the second element 2 may be cleaned with a suitable cleaning agent, *e.g.,* the cleaned surface may treated with more than one type of plasma (ashing plasma and nitrogen bearing plasma), and may be rinsed before coating with a protective layer 65. The protective layer 65 can be stripped from the bonding surfaces after the thinning and singulation process. In a block 50 of Figure 2A, and as shown in Figure 3E, the cleaned activated bonding surface 64' of the singulated first element 1 can be directly bonded to the cleaned bonding surface of the second element 2. In some applications, the singulated second element 2 can be larger than the singulated first element 1, for example, in embodiments in which the first element 1 in the form of a device die is bonded to the second element 2 in the form of a wafer or larger carrier or interposer.

Figure 2B illustrates an alternative process for forming the second element 2. Unless otherwise noted, the steps of Figure 2B are generally the same as the steps of Figure 2A. Unlike the embodiment of Figure 2A, in the embodiment of Figure 2B, the second element 2 may not be activated and subsequently coated with a protective layer. Rather, in block 46, the second element 2 can be planarized and cleaned. In block 49, the bonding surface can be dry and/or wet cleaned (and/or also cleaned with a DIW cleaning step). In a block 51, the second element 2 can be activated and cleaned with deionized water (DIW) before bonding in block 50. Thus, in Figure 2B, the activation step for the second element 2 may not precede application of the protective coating. In still other embodiments, as explained above, the second element 2 may not be activated at all.

As shown in Figure 3E, the first and second elements 1, 2 can be brought together in contact with one another to form a bonded structure 70 including direct bonds along a bond interface 72 between the nonconductive bonding regions 60 of the first and second elements 1, 2. The structure 70 can be annealed, and the contact pads 63 can extend to make direct contact and an electrical connection. Beneficially, one or both of the first and second elements 1, 2 can be activated prior to application of the protective layer and singulation. Activation prior to singulation can beneficially enable the element(s) 1, 2 to be activated (which may beneficially improve bonding energy) without damaging the dicing tape so as to make activation compatible with the dicing process. The protective layer 65 applied over the activated surface 64' can also enable the protected element 1 in wafer form to be stored and/or transported to a different facility before bonding. For example, the first element 1 in wafer form shown in Figure 3C can be stored for days (*e.g.,* at least 24 hours), weeks, months, etc. before being bonded. The protective layer 65 can protect the activated surface 64', which can remain suitable for direct bonding at a later time, and/or can enable the protected wafer to be shipped from a facility in one location (*e.g*., where the wafer was activated and the protective layer 65 applied) to another different facility in a different location (e.g., where the first element 1 in wafer form can be singulated and directly bonded to the second element 2).

Moreover, in some embodiments, the protective layer 65 can adhere better to the activated surface 64' as compared to an unactivated surface. Additionally, activation of the bonding surface 64 prior to deposition of the protective layer 65 can serve to protect the contact pads 63 (which may comprise copper). In the arrangement of Figure 1, the protective layer deposition and removal may chemically etch or remove portions of the metallic material from the contact pads 63, which can deepen the recess of the pads 63. Deeper recesses may result in incomplete electrical contact after annealing and/or the use of higher temperatures which can be undesirable. By activating the bonding surface 64 (including the contact pads 63), the activation can serve a passivation function which can protect the underlying contact pads 63 during subsequent processing (*e.g*., during deposition and removal of the protective layer 65).

The embodiments disclosed herein can be used for die-to-wafer (D2W) and die-to-die (D2D) applications in which one or a plurality of singulated elements 1 (*e.g.,* singulated integrated device dies) are directly bonded to an element 2 (*e.g.,* a wafer) that is larger than or the equal size with the singulated elements 1. In other embodiments, the embodiments disclosed herein can be used for wafer-to-wafer (W2W) applications in which the first element 1 in wafer form is directly bonded to another wafer. The activation and protective layer 65 can be provided on both elements 1, 2, or on only one element of the bonded structure 70. For example, in the embodiment of Figures 2A-2B, the first element 1 is initially in wafer form before being singulated and directly bonded to the second element 2. In Figures 2A-2B, the second element 2 is in wafer form for the direct bonding (*e.g*., as a semiconductor wafer, substrate, interposer, or other carrier), but in other embodiments, the second element 2 may also be in the form of a singulated die for direct bonding. In still other embodiments, both the first and second elements 1, 2 may be in wafer form for the direct bonding and, after direct bonding, singulated to form a plurality of bonded structures.

As explained herein, the first and second elements 1, 2 can be directly bonded to one another without an adhesive, which is different from a deposition process. The first and second elements 1, 2 can accordingly comprise non-deposited elements. Further, directly bonded structures 70, unlike deposited layers, can include a defect region along the bond interface 72 in which nanovoids are present. The nanovoids may be formed due to activation of the bonding surfaces 64 (e.g., exposure to a plasma). As explained above, the bond interface 72 can include concentration of materials from the activation and/or last chemical treatment processes. For example, in embodiments that utilize a nitrogen plasma for activation, a nitrogen peak can be formed at the bond interface 72. In embodiments that utilize an oxygen plasma for activation, an oxygen peak can be formed at the bond interface. In some embodiments, the bond interface 72 can comprise silicon oxynitride, silicon oxycarbonitride, or silicon carbonitride. As explained herein, the direct bond can comprise a covalent bond, which is stronger than van Der Waals bonds. The bonding layers 62 can also comprise polished surfaces that are planarized to a high degree of smoothness.

In various embodiments, the metal-to-metal bonds between the contact pads 63 can be joined such that copper grains grow into each other across the bond interface 72. In some embodiments, the copper can have grains oriented along the 111 crystal plane for improved copper diffusion across the bond interface 72. The bond interface 72 can extend substantially entirely to at least a portion of the bonded contact pads 63, such that there is substantially no gap between the nonconductive bonding regions 60 at or near the bonded contact pads 63. In some embodiments, a barrier layer may be provided under the contact pads 63 (*e.g.,* which may include copper). In other embodiments, however, there may be no barrier layer under the contact pads 63, for example, as described in US 2019/0096741.

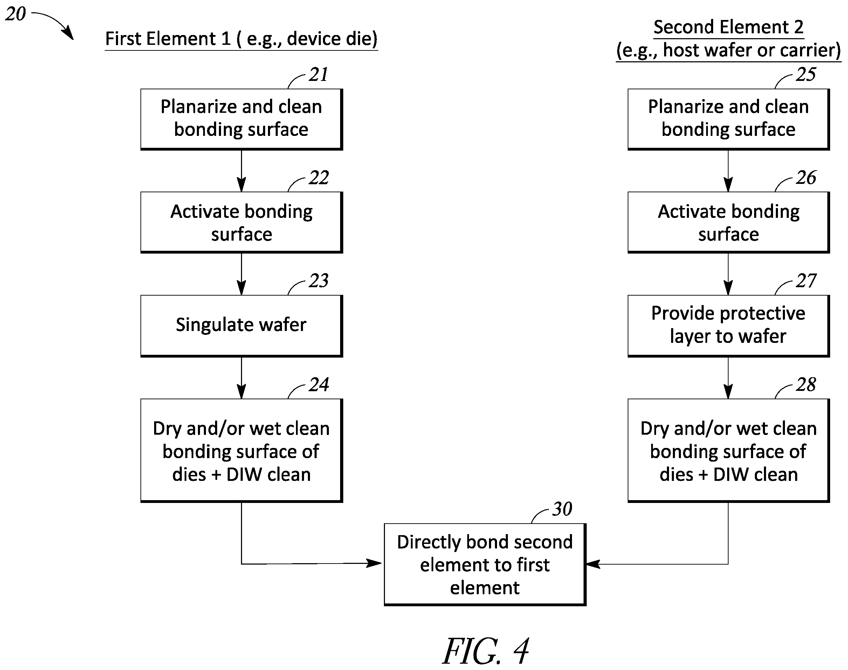

Figure 4 illustrates another method of forming a bonded structure 70. Unless otherwise noted, the steps and components referenced in Figure 4 may be the same as or generally similar to like-numbered components of Figures 2A-3E. For example, as with the embodiment of Figures 2A-2B, the bonding surface 64 of the first element 1 can be planarized and cleaned in a block 21. The bonding surface 64 of the first element 1 can be activated in a block 22. However, in Figure 4, there may be no protective layer provided before singulation. Rather, the first element 1 in wafer form can be singulated in a block 44. Debris from the singulation process (or other processing steps) can be removed by dry and/or wet clean processes in a block 45 (which may include a DIW cleaning step). In the embodiment of Figure 4, the cleaning agent(s) may be suitably selected so as to remove any debris created during singulation. The second element 2 may be processed in a manner similar to that shown in Figure 2A or 2B. The first and second elements 1, 2 can be directly bonded without an adhesive.

In some embodiments, the protective layer comprises an organic layer. In some embodiments, the protective layer comprises a photoresist. In some embodiments, the method can include removing the protective layer. In some embodiments, the first element is in the form of wafer before providing the protective layer, the method further comprising, before removing the protective layer, singulating the first element in wafer form to form a plurality of singulated first elements. The method can include, after removing the protective layer, directly bonding the first bonding layer of the first element to the second bonding layer of the second element without an intervening adhesive. In some embodiments, the method can include rinsing at least one of the first and second bonding layers with deionized water (DIW) after removing the protective layer. In some embodiments, after removing the protective layer, the first element is in the form of a singulated integrated device die and the second element is in the form of a wafer. In some embodiments, the conductive contact pads comprise copper or copper alloy. In some embodiments, the non-conductive bonding region comprises a silicon-containing dielectric layer. In some embodiments, the non-conductive bonding region comprises a non-silicon dielectric layer that does not include silicon. In some embodiments, activating the first bonding layer and providing the protective layer are performed in a first facility, and wherein directly bonding is performed at a second facility that is in a different location from the first facility. In some embodiments, directly bonding is performed more than twenty-four (24) hours after activating the first bonding layer. In some embodiments, activating the first bonding layer comprises plasma activating the first bonding layer. In some embodiments, plasma activating the first bonding layer comprises exposing the first bonding layer to a nitrogen-containing plasma. In some embodiments, the first bonding layer comprises silicon oxide or silicon carbonitride. In some embodiments, plasma activating the first bonding layer comprises exposing the first bonding layer to an oxygen-containing plasma. In some embodiments, the first bonding layer comprises silicon nitride or silicon carbonitride. In some embodiments, providing the protective layer comprises depositing the protective layer over the activated bonding layer of the first element.

The scope of the invention is defined by the claims.

## Claims

1. A method for preparing a first element (1) for direct bonding to a second element, the method comprising:
activating (42) a first bonding layer (62) of the first element for direct bonding to a second bonding layer of the second element, wherein the first bonding layer comprises a plurality of conductive contact pads (63) and a non-conductive bonding region (60);
**characterised in** the method further comprising:
after the activating, providing (43) a protective layer (65) over the activated first bonding layer (64') of the first element such that the protective layer is over the plurality of conductive contact pads and the non-conductive bonding region.

2. The method of Claim 1, wherein the protective layer comprises an organic layer.

3. The method of Claim 1, further comprising removing the protective layer.

4. The method of Claim 3, wherein the first element is in the form of a wafer before providing the protective layer, the method further comprising, before removing the protective layer, singulating the first element in wafer form to form a plurality of singulated first elements.

5. The method of Claim 3, further comprising rinsing at least one of the first and second bonding layers with deionized water, DIW, after removing the protective layer.

6. The method of Claim 3, wherein, after removing the protective layer, the first element is in the form of a singulated integrated device die and the second element is in the form of a wafer.

7. The method of Claim 1, wherein the conductive contact pads comprise copper or copper alloy.

8. The method of Claim 1, wherein the non-conductive bonding region comprises a silicon-containing dielectric layer.

9. The method of Claim 1, wherein activating the first bonding layer comprises plasma activating the first bonding layer.

10. The method of Claim 9, wherein plasma activating the first bonding layer comprises exposing the first bonding layer to a nitrogen-containing plasma.

11. The method of Claim 9, wherein plasma activating the first bonding layer comprises exposing the first bonding layer to an oxygen-containing plasma.

12. The method of Claim 1, wherein providing the protective layer comprises depositing the protective layer over the activated bonding layer of the first element.

## Patentansprüche

1. Ein Verfahren zum Vorbereiten eines ersten Elements (1) zum direkten Bonden an ein zweites Element, wobei das Verfahren Folgendes beinhaltet:
Aktivieren (42) einer ersten Bondschicht (62) des ersten Elements zum direkten Bonden an eine zweite Bondschicht des zweiten Elements, wobei die erste Bondschicht eine Vielzahl von leitfähigen Kontaktpads (63) und einen nichtleitfähigen Bondbereich (60) beinhaltet;
**dadurch gekennzeichnet, dass** das Verfahren ferner Folgendes beinhaltet:
nach dem Aktivieren, Bereitstellen (43) einer Schutzschicht (65) über der aktivierten ersten Bondschicht (64') des ersten Elements, sodass sich die Schutzschicht über der Vielzahl von leitfähigen Kontaktpads und dem nichtleitfähigen Bondbereich befindet.

2. Verfahren gemäß Anspruch 1, wobei die Schutzschicht eine organische Schicht beinhaltet.

3. Verfahren gemäß Anspruch 1, das ferner das Entfernen der Schutzschicht beinhaltet.

4. Verfahren gemäß Anspruch 3, wobei das erste Element vor dem Bereitstellen der Schutzschicht in Form eines Wafers vorliegt, wobei das Verfahren ferner vor dem Entfernen der Schutzschicht das Vereinzeln des ersten Elements in Waferform beinhaltet, um eine Vielzahl von vereinzelten ersten Elementen zu bilden.

5. Verfahren gemäß Anspruch 3, das ferner das Spülen mindestens einer der ersten und der zweiten Bondschicht mit deionisiertem Wasser, DIW, nach dem Entfernen der Schutzschicht beinhaltet.

6. Verfahren gemäß Anspruch 3, wobei das erste Element nach dem Entfernen der Schutzschicht in Form eines vereinzelten Dies einer integrierten Vorrichtung vorliegt und das zweite Element in Form eines Wafers vorliegt.

7. Verfahren gemäß Anspruch 1, wobei die leitfähigen Kontaktpads Kupfer oder eine Kupferlegierung beinhalten.

8. Verfahren gemäß Anspruch 1, wobei der nichtleitfähige Bondbereich eine siliziumhaltige dielektrische Schicht beinhaltet.

9. Verfahren gemäß Anspruch 1, wobei das Aktivieren der ersten Bondschicht das Plasmaaktivieren der ersten Bondschicht beinhaltet.

10. Verfahren gemäß Anspruch 9, wobei das Plasmaaktivieren der ersten Bondschicht das Aussetzen der ersten Bondschicht gegenüber einem stickstoffhaltigen Plasma beinhaltet.

11. Verfahren gemäß Anspruch 9, wobei das Plasmaaktivieren der ersten Bondschicht das Aussetzen der ersten Bondschicht gegenüber einem sauerstoffhaltigen Plasma beinhaltet.

12. Verfahren gemäß Anspruch 1, wobei das Bereitstellen der Schutzschicht das Abscheiden der Schutzschicht über der aktivierten Bondschicht des ersten Elements beinhaltet.

## Revendications

1. Un procédé destiné à la préparation d'un premier élément (1) en vue d'un collage direct à un deuxième élément, le procédé comprenant :
l'activation (42) d'une première couche de collage (62) du premier élément en vue d'un collage direct à une deuxième couche de collage du deuxième élément, dans lequel la première couche de collage comprend une pluralité de plots de contact conducteurs (63) et une région de collage non conductrice (60) ;
**caractérisé en ce que** le procédé comprend en outre :
après l'activation, la fourniture (43) d'une couche de protection (65) par-dessus la première couche de collage activée (64') du premier élément de telle sorte que la couche de protection se situe par-dessus la pluralité de plots de contact conducteurs et la région de collage non conductrice.

2. Le procédé de la revendication 1, dans lequel la couche de protection comprend une couche organique.

3. Le procédé de la revendication 1, comprenant en outre le retrait de la couche de protection.

4. Le procédé de la revendication 3, dans lequel le premier élément se présente sous la forme d'une tranche avant la fourniture de la couche de protection, le procédé comprenant en outre, avant le retrait de la couche de protection, la singularisation du premier élément sous forme de tranche afin de former une pluralité de premiers éléments singularisés.

5. Le procédé de la revendication 3, comprenant en outre le rinçage d'au moins l'une des première et deuxième couches de collage avec de l'eau désionisée, DIW, après le retrait de la couche de protection.

6. Le procédé de la revendication 3, dans lequel, après le retrait de la couche de protection, le premier élément se présente sous la forme d'un dé de dispositif intégré singularisé et le deuxième élément se présente sous la forme d'une tranche.

7. Le procédé de la revendication 1, dans lequel les plots de contact conducteurs comprennent du cuivre ou un alliage de cuivre.

8. Le procédé de la revendication 1, dans lequel la région de collage non conductrice comprend une couche diélectrique contenant du silicium.

9. Le procédé de la revendication 1, dans lequel l'activation de la première couche de collage comprend l'activation par plasma de la première couche de collage.

10. Le procédé de la revendication 9, dans lequel l'activation par plasma de la première couche de collage comprend l'exposition de la première couche de collage à un plasma contenant de l'azote.

11. Le procédé de la revendication 9, dans lequel l'activation par plasma de la première couche de collage comprend l'exposition de la première couche de collage à un plasma contenant de l'oxygène.

12. Le procédé de la revendication 1, dans lequel la fourniture de la couche de protection comprend le dépôt de la couche de protection par-dessus la couche de collage activée du premier élément.
